(19) **Europäisches Patentamt European Patent Office Office européen des brevets**

(11) **EP 4 319 197 B1**

(12) **EUROPEAN PATENT SPECIFICATION**

(45) Date of publication and mention
of the grant of the patent:
**21.01.2026 Bulletin 2026/04**

(21) Application number: **22774991.8**

(22) Date of filing: **03.03.2022**

(51) International Patent Classification (IPC):
*H10N 30/50* (2023.01)    *H10N 30/85* (2023.01)
*H04R 17/00* (2006.01)    *C04B 35/491* (2006.01)
*H10N 30/87* (2023.01)

(52) Cooperative Patent Classification (CPC):
**H10N 30/50; C04B 35/491; H04R 17/00;
H10N 30/852;** C04B 2235/5296; C04B 2235/5436;
C04B 2235/5445; H10N 30/883

(86) International application number:
**PCT/JP2022/009174**

(87) International publication number:
**WO 2022/202195 (29.09.2022 Gazette 2022/39)**

(54) **PIEZOELECTRIC FILM**

PIEZOELEKTRISCHE FOLIE

FILM PIÉZOÉLECTRIQUE

(84) Designated Contracting States:
**AL AT BE BG CH CY CZ DE DK EE ES FI FR GB
GR HR HU IE IS IT LI LT LU LV MC MK MT NL NO
PL PT RO RS SE SI SK SM TR**

(30) Priority: **26.03.2021 JP 2021052766**

(43) Date of publication of application:
**07.02.2024 Bulletin 2024/06**

(73) Proprietor: **FUJIFILM Corporation
Tokyo 106-8620 (JP)**

(72) Inventor: **ISHIDA, Jumpei
Minamiashigara-shi, Kanagawa 250-0193 (JP)**

(74) Representative: **Klunker IP
Patentanwälte PartG mbB
Destouchesstraße 68
80796 München (DE)**

(56) References cited:
WO-A1-2020/095812     WO-A1-2020/095812
WO-A1-2020/261837     JP-A- 2014 162 685
US-A1- 2012 104 309     US-A1- 2015 364 674

## Description

### BACKGROUND OF THE INVENTION

1. Field of the Invention

The present invention relates to a piezoelectric film.

2. Description of the Related Art

With reduction in thickness of displays such as liquid crystal displays or organic EL displays, speakers used in these thin displays are also required to be lighter and thinner. Further, in flexible displays having flexibility, speakers are also required to have flexibility in order to be integrated with flexible displays without impairing lightness and flexibility. As such lightweight, thin, and flexible speakers, it is considered to employ sheet-like piezoelectric films having a property of stretching and contracting in response to an applied voltage.

It is also considered that a speaker having flexibility is obtained by bonding an exciter having flexibility to a vibration plate having flexibility. An exciter is an exciton that vibrates an article and produces a sound by being brought into contact with various articles and being attached thereto.

It has been suggested to use a piezoelectric composite material containing piezoelectric particles in a matrix as a sheet-like piezoelectric film having flexibility or an exciter.

For example, JP6043673B describes a polymer-based piezoelectric composite material for electroacoustic conversion, formed by dispersing piezoelectric particles in a matrix consisting of a polymer material, in which the piezoelectric particles contain lead zirconate titanate represented by General Formula $Pb(Zr_xTi_{1-x})O_3$ as a main component, a tetragonal crystal and a rhombohedral crystal are mixed in each of the piezoelectric particles, the particle diameter of the piezoelectric particles measured by a laser scattering particle size measuring device is in a range of 2 to 5 $\mu$m in terms of the median diameter ($D_{50}$), the proportion of the piezoelectric particles having a particle diameter of 10 $\mu$m or greater is in a range of 5% to 30% by volume of the entirety of the piezoelectric particles, and the proportion of the piezoelectric particles having a particle diameter of 1 $\mu$m or less is 10% by volume or less of the entirety of the piezoelectric particles. Further, JP6043673B describes that an electroacoustic conversion film obtained by providing electrode layers on both surfaces of the polymer-based piezoelectric composite material is used.

US2015/0364674 A1 discloses a piezoelectric film having the features of the preamble of claim 1.

WO 2020/095812 A1 discloses a laminated piezoelectric element.

### SUMMARY OF THE INVENTION

There has been a demand for such a piezoelectric film to have higher conversion efficiency between electrical energy and mechanical energy, that is, piezoelectric performance.

An object of the present invention is to solve such a problem of the related art and to provide a piezoelectric film having high piezoelectric performance.

In order to achieve the above-described object, the present invention has the following configurations.

A piezoelectric film comprising: a piezoelectric layer consisting of a polymer-based piezoelectric composite material that contains piezoelectric particles in a matrix containing a polymer material; and electrode layers formed on both surfaces of the piezoelectric layer, in which the piezoelectric particles observed in a cross section of the piezoelectric layer in a thickness direction have a circularity of 0.80 to 0.88.

A laminated piezoelectric element formed by laminating a plurality of layers of the piezoelectric film.

According to the present invention as described above, it is possible to provide a piezoelectric film having high piezoelectric performance.

### BRIEF DESCRIPTION OF THE DRAWINGS

Fig. 1 is a view conceptually illustrating an example of a piezoelectric film of the present invention.
Fig. 2 is a conceptual view for describing an example of a method of preparing a piezoelectric film.
Fig. 3 is a conceptual view for describing an example of a method of preparing a piezoelectric film.
Fig. 4 is a conceptual view for describing an example of a method of preparing a piezoelectric film.
Fig. 5 is a conceptual view for describing an example of a method of preparing a piezoelectric film.
Fig. 6 is a view conceptually illustrating an example of a piezoelectric element including the piezoelectric film of the present invention.

Fig. 7 is a view conceptually illustrating another example of the piezoelectric element including the piezoelectric film of the present invention.

## DESCRIPTION OF THE PREFERRED EMBODIMENTS

Hereinafter, the piezoelectric film according to the embodiment of the present invention will be described in detail based on the preferred embodiments shown in the accompanying drawings.

The description of configuration requirements described below may be made based on typical embodiments of the present invention, but the present invention is not limited to such embodiments.

In addition, in the present specification, a numerical range shown using "to" indicates a range including numerical values described before and after "to" as a lower limit and an upper limit.

[Piezoelectric film]

A piezoelectric film according to the embodiment of the present invention is a piezoelectric film including a piezoelectric layer consisting of a polymer-based piezoelectric composite material that contains piezoelectric particles in a matrix containing a polymer material, and electrode layers formed on both surfaces of the piezoelectric layer, in which the piezoelectric particles observed in a cross section of the piezoelectric layer in a thickness direction have a circularity of 0.80 to 0.88.

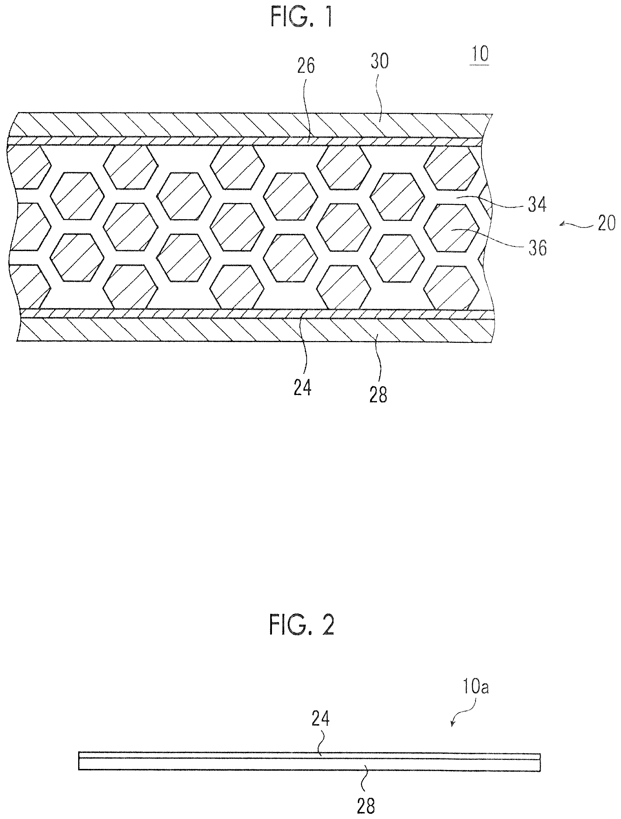

Fig. 1 conceptually illustrates an example of the piezoelectric film according to the embodiment of the present invention.

As illustrated in Fig. 1, the piezoelectric film 10 includes a piezoelectric layer 20 which is a sheet-like material having piezoelectric properties, a first electrode layer 24 laminated on one surface of the piezoelectric layer 20, a first protective layer 28 laminated on the first electrode layer 24, a second electrode layer 26 laminated on the other surface of the piezoelectric layer 20, and a second protective layer 30 laminated on the second electrode layer 26.

The piezoelectric layer 20 consists of a polymer-based piezoelectric composite material containing the piezoelectric particles 36 in a matrix 34 containing a polymer material. In addition, the first electrode layer 24 and the second electrode layer 26 are electrode layers of the present invention.

As will be described below, the piezoelectric film 10 (piezoelectric layer 20) is polarized in the thickness direction as a preferred embodiment.

As an example, the piezoelectric film 10 is used in various acoustic devices (audio equipment) such as speakers, microphones, and pickups used in musical instruments such as guitars, to generate (reproduce) a sound due to vibration in response to an electrical signal or convert vibration due to a sound into an electrical signal.

Further, the piezoelectric film can also be used in pressure sensitive sensors, power generation elements, and the like in addition to the examples described above.

Alternatively, the piezoelectric film can also be used as an exciter that vibrates an article and generates a sound by being brought into contact with and attached to various articles.

In the piezoelectric film 10, the second electrode layer 26 and the first electrode layer 24 form a pair of electrodes. That is, the piezoelectric film 10 has a configuration in which both surfaces of the piezoelectric layer 20 are sandwiched between the electrode pair, that is, the first electrode layer 24 and the second electrode layer 26, and the laminate is further sandwiched between the first protective layer 28 and the second protective layer 30.

As described above, in the piezoelectric film 10, the region sandwiched between the first electrode layer 24 and the second electrode layer 26 stretches and contracts according to the applied voltage.

Further, the first electrode layer 24 and the first protective layer 28, and the second electrode layer 26 and the second protective layer 30 are named according to the polarization direction of the piezoelectric layer 20. Therefore, the first electrode layer 24 and the second electrode layer 26, and the first protective layer 28 and the second protective layer 30 have configurations that are basically the same as each other.

Further, in addition to the above-described layers, for example, the piezoelectric film 10 may include an insulating layer that covers a region where the piezoelectric layer 20 on a side surface or the like is exposed for preventing a short circuit or the like.

In a case where a voltage is applied to the first electrode layer 24 and the second electrode layer 26 of the piezoelectric film 10, the piezoelectric particles 36 stretch and contract in the polarization direction according to the applied voltage. As a result, the piezoelectric film 10 (piezoelectric layer 20) contracts in the thickness direction. At the same time, the piezoelectric film 10 stretches and contracts in the in-plane direction due to the Poisson's ratio. The degree of stretch and contraction is approximately in a range of 0.01% to 0.1%. In the in-plane direction, the stretch and contraction are isotropically made in all directions.

The thickness of the piezoelectric layer 20 is preferably approximately in a range of 10 to 300 $\mu$m. Therefore, the

degree of stretch and contraction in the thickness direction is as extremely small as approximately 0.3 $\mu$m at the maximum.

On the contrary, the piezoelectric film 10, that is, the piezoelectric layer 20, has a size much larger than the thickness in the plane direction. Therefore, for example, in a case where the length of the piezoelectric film 10 is 20 cm, the piezoelectric film 10 stretches and contracts by a maximum of approximately 0.2 mm by the application of a voltage.

Further, in a case where a pressure is applied to the piezoelectric film 10, electric power is generated by the action of the piezoelectric particles 36.

By utilizing this, the piezoelectric film 10 can be used for various applications such as a speaker, a microphone, and a pressure sensitive sensor as described above.

Here, in the piezoelectric film 10 according to the embodiment of the present invention, the piezoelectric particles observed in a cross section of the piezoelectric layer in the thickness direction have a circularity of 0.80 to 0.88.

The circularity is expressed by "$4\pi \times$ (area) $\div$ (circumference length)$^2$" and represents the complexity of the shape. The circularity is 1 in a case of a perfect circle, and the numerical value of the circularity decreases as the shape is more complicated.

As described above, in a case where a voltage is applied to the piezoelectric film formed of the piezoelectric layer consisting of a polymer-based piezoelectric composite material that contains piezoelectric particles in a matrix containing a polymer material, the piezoelectric particles 36 stretch and contract in the polarization direction, the piezoelectric film 10 (piezoelectric layer 20) stretches and contracts, and thus the electrical energy is converted into mechanical energy.

Here, according to the examination conducted by the present inventors, it was found that in a case where the piezoelectric particles 36 have a shape close to a perfect circle, that is, the piezoelectric particles 36 have a circularity of close to 1, since the interaction between adjacent piezoelectric particles 36 occurs between points, the force due to the stretch and contraction is unlikely to be transmitted, the mechanical energy of the piezoelectric particles is unlikely to be transmitted to the outside as the mechanical energy of the entire piezoelectric film, and thus the efficiency (piezoelectric performance) of converting the electrical energy into the mechanical energy is unlikely to sufficiently increase.

Meanwhile, in a case where the circularity of the piezoelectric particles 36 is extremely small, since the shape of the piezoelectric particles 36 is extremely complicated, voids are generated in a case where a coating material obtained by dispersing the piezoelectric particles in the matrix and a solvent is applied and dried so that the solvent is volatilized during the formation of the piezoelectric layer, and thus the filling ratio of the piezoelectric layer is decreased. Therefore, the piezoelectric performance is found to be degraded.

On the contrary, in the piezoelectric film according to the embodiment of the present invention, the piezoelectric particles 36 have a shape with appropriate angles by setting the circularity of the piezoelectric particles 36 to 0.88 or less. Therefore, in a case where the piezoelectric particles 36 stretch and contract in the polarization direction due to application of a voltage, since the interaction between the adjacent piezoelectric particles 36 occurs between the surfaces, a force due to the stretch and contraction is likely to be transmitted, and thus the mechanical energy of the piezoelectric particles 36 is likely to be transmitted to the outside as the mechanical energy of the entire piezoelectric film. Therefore, the efficiency (piezoelectricity performance) of converting the electrical energy into the mechanical energy is further increased.

Further, generation of voids in a case where the coating material that is formed into the piezoelectric layer is applied and dried so that the solvent is volatilized during the formation of the piezoelectric layer can be suppressed by setting the circularity of the piezoelectric particles 36 in the piezoelectric film according to the embodiment of the present invention to 0.80 or greater, that is, preventing the shape of the piezoelectric particles 36 from being extremely complicated. Therefore, a decrease in the filling ratio of the piezoelectric layer can be prevented, and thus a piezoelectric film having high piezoelectric performance can be obtained.

From the viewpoint of further improving the piezoelectric performance and according to the invention, the circularity of the piezoelectric particles 36 is in a range of 0.80 to 0.88.

Hereinafter, an example of a method of measuring the circularity of the piezoelectric particles will be described.

A sample is cut out from the piezoelectric film and machined in the thickness direction for observation of a cross section. The piezoelectric film is machined by mounting a histo knife blade (manufactured by Drukker) having a width of 8 mm on RM2265 (manufactured by Leica Biosystems) and setting the speed to a controller scale of 1 and an engagement amount of 0.25 to 1 $\mu$m.

Next, the cross section is observed with a scanning electron microscope (SEM) using the sample with the cross section that has been processed. For example, S-4800 (manufactured by Hitachi High-Tech Corporation) can be used as the SEM. In addition, the sample may be subjected to a conductive treatment. For example, the sample is subjected to a conductive treatment with platinum vapor deposition, and the work distance may be set to 2.8 mm.

The observation is carried out with a secondary-electron (SE) image by setting an SE detector to upper (U) and +BSE L. A. 100. The observation is carried out under conditions of an acceleration voltage of 2 kV and a probe current of high, focus adjustment and astigmatism adjustment are performed produce a sharpest image, and automatic brightness adjustment (auto setting brightness: 0, contrast: 0) is performed in a state where the piezoelectric film covers the entire screen.

The imaging magnification is set as the magnification such that the first electrode layer and the second electrode layer fit on one screen and the width between the electrodes reaches a half or greater of the screen. Here, an image is captured such that two electrode layers are horizontal to the lower portion of the image.

The image acquired as described above is binarized. Specifically, first, linear conversion is made by setting the density range of the original imaging data to be in a gradation range of 0 (dark) to 255 (bright) using image analysis software WinROOF, to enhance the contrast. Subsequently, the piezoelectric layer is selected in a rectangular shape so that the selected area is maximized in a range not including the first electrode layer and the second electrode layer, and a portion in gradation with a density range of 110 to 255 is binarized.

Subsequently, in order to remove noise components in which only one pixel part is selected for the binarized part and to separate particles that appear to be bonded, the conditions for three times of a contraction treatment that is an analysis function of WinROOF are selected and the treatment is performed, the conditions for three times of an exclusive expansion treatment are selected and the treatment is performed once, and a circular separation treatment is performed once, to obtain a binarized image of piezoelectric particles for circularity analysis.

Subsequently, the circularity of each binarized piezoelectric particle is acquired, and the arithmetic average value thereof is acquired. As described above, the circularity is $4\pi \times$ (area/(circumference length)$^2$), and a relationship of "$0 <$ circularity $\leq 1$" is satisfied. In the observation of the cross section with an SEM, N5 visual field measurement is performed, the circularity is acquired for each measurement visual field, and the average value of the circularity values of the N5 visual field is acquired and defined as the circularity of the piezoelectric particles in the piezoelectric film.

Here, from the viewpoint of further improving the piezoelectric performance, the average particle diameter of the piezoelectric particles is preferably in a range of 0.5 $\mu$m to 5 $\mu$m, more preferably in a range of 0.7 $\mu$m to 4 $\mu$m, and still more preferably in a range of 0.9 $\mu$m to 3 $\mu$m.

The average particle diameter of the piezoelectric particles is obtained by acquiring the circle-equivalent diameter of each piezoelectric particle using an image binarized by the above-described method and calculating the average value thereof. The N5 visual field measurement of the cross section is also performed for the average particle diameter, and the average particle diameter is acquired for each measurement visual field and defined as the average particle diameter of the piezoelectric particles in the piezoelectric film.

<Piezoelectric layer>

The piezoelectric layer is a layer consisting of a polymer-based piezoelectric composite material that contains piezoelectric particles in a matrix containing a polymer material and is a layer that exhibits a piezoelectric effect in which the layer is stretched and contracted in a case where a voltage is applied.

In the piezoelectric film 10, as a preferred embodiment, the piezoelectric layer 20 consists of a polymer-based piezoelectric composite material in which piezoelectric particles 36 are dispersed in the matrix 34 consisting of a polymer material having viscoelasticity at room temperature. Further, in the present specification, "room temperature" indicates a temperature range of approximately 0°C to 50°C.

The piezoelectric film 10 according to the embodiment of the present invention is suitably used for a speaker having flexibility such as a speaker for a flexible display. Here, it is preferable that the polymer-based piezoelectric composite material (piezoelectric layer 20) used for a speaker having flexibility satisfies the following requirements. Therefore, it is preferable that a polymer material having viscoelasticity at room temperature is used as a material satisfying the following requirements.

(i) Flexibility

For example, in a case of being gripped in a state of being loosely bent like a document such as a newspaper or a magazine as a portable device, the piezoelectric film is continuously subjected to large bending deformation from the outside at a relatively slow vibration of less than or equal to a few Hz. In this case, in a case where the polymer-based piezoelectric composite material is hard, a large bending stress is generated to that extent, and a crack is generated at the interface between a polymer matrix and piezoelectric particles, which may lead to breakage. Accordingly, the polymer-based piezoelectric composite material is required to have suitable flexibility. In addition, in a case where strain energy is diffused into the outside as heat, the stress is able to be relaxed. Therefore, the polymer-based piezoelectric composite material is required to have a suitably large loss tangent.

(ii) Acoustic quality

In a speaker, the piezoelectric particles vibrate at a frequency of an audio band of 20 Hz to 20 kHz, and the vibration energy causes the entire polymer-based piezoelectric composite material (piezoelectric film) to vibrate integrally so that a sound is reproduced. Therefore, in order to increase the transmission efficiency of the vibration energy, the polymer-based piezoelectric composite material is required to have appropriate hardness. In addition, in a case where the frequencies of the speaker are smooth as the frequency characteristic thereof, an amount of change in acoustic quality in a case where the lowest resonance frequency is changed in association with a change in the curvature of the speaker decreases. Therefore, the polymer-based piezoelectric composite material is required to have a suitably large loss tangent.

That is, the polymer-based piezoelectric composite material is required to exhibit a behavior of being hard with respect to a vibration of 20 Hz to 20 kHz and being flexible with respect to a vibration of less than or equal to a few Hz. In addition, the loss tangent of a polymer-based piezoelectric composite material is required to be suitably large with respect to the vibration of all frequencies of 20 kHz or less.

In general, a polymer solid has a viscoelasticity relaxing mechanism, and a molecular movement having a large scale is observed as a decrease (relief) in a storage elastic modulus (Young's modulus) or a maximal value (absorption) in a loss elastic modulus along with an increase in temperature or a decrease in frequency. Among these, the relaxation due to a microbrown movement of a molecular chain in an amorphous region is referred to as main dispersion, and an extremely large relaxing phenomenon is observed. A temperature at which this main dispersion occurs is a glass transition point (Tg), and the viscoelasticity relaxing mechanism is most remarkably observed.

In the polymer-based piezoelectric composite material (piezoelectric layer 20), the polymer-based piezoelectric composite material exhibiting a behavior of being rigid with respect to a vibration of 20 Hz to 20 kHz and being flexible with respect to a vibration of less than or equal to a few Hz is realized by using a polymer material whose glass transition point is room temperature, that is, a polymer material having a viscoelasticity at room temperature as a matrix. In particular, from the viewpoint that such a behavior is suitably exhibited, it is preferable that a polymer material in which the glass transition point at a frequency of 1 Hz is at room temperature, that is, in a range of 0°C to 50°C is used for a matrix of the polymer-based piezoelectric composite material.

As the polymer material having a viscoelasticity at room temperature, various known materials can be used. It is preferable that a polymer material in which the maximal value of a loss tangent Tanδ at a frequency of 1 Hz according to a dynamic viscoelasticity test at room temperature, that is, in a range of 0°C to 50°C is 0.5 or greater is used as the polymer material. In this manner, in a case where the polymer-based piezoelectric composite material is slowly bent due to an external force, stress concentration on the interface between the polymer matrix and the piezoelectric particles at the maximum bending moment portion is relaxed, and thus high flexibility can be expected.

In the polymer material having a viscoelasticity at room temperature, it is preferable that a storage elastic modulus (E') at a frequency of 1 Hz according to the dynamic viscoelasticity measurement is 100 MPa or greater at 0°C and 10 MPa or less at 50°C. In this manner, the bending moment generated in a case where the polymer-based piezoelectric composite material is slowly bent due to the external force can be reduced, and the polymer-based piezoelectric composite material can exhibit a behavior of being rigid with respect to an acoustic vibration of 20 Hz to 20 kHz.

In addition, it is more suitable that the relative dielectric constant of the polymer material having a viscoelasticity at room temperature is 10 or greater at 25°C. Accordingly, in a case where a voltage is applied to the polymer-based piezoelectric composite material, a higher electric field is applied to the piezoelectric particles in the polymer matrix, and thus a large deformation amount can be expected. However, in consideration of ensuring satisfactory moisture resistance and the like, it is suitable that the relative dielectric constant of the polymer material is 10 or less at 25°C.

Examples of the polymer material having a viscoelasticity at room temperature and satisfying such conditions include cyanoethylated polyvinyl alcohol (cyanoethylated PVA), polyvinyl acetate, polyvinylidene chloride-co-acrylonitrile, a polystyrene-vinyl polyisoprene block copolymer, polyvinyl methyl ketone, and polybutyl methacrylate. In addition, as these polymer materials, a commercially available product such as Hybrar 5127 (manufactured by Kuraray Co., Ltd.) can also be suitably used. Among these, it is preferable to use a material containing a cyanoethyl group and particularly preferable to use cyanoethylated PVA as the polymer material. Further, these polymer materials may be used alone or in combination (mixture) of a plurality of kinds thereof.

In the matrix 34 for which such a polymer material having a viscoelasticity at room temperature is used, a plurality of polymer materials may be used in combination as necessary. That is, other dielectric polymer materials may be added to the matrix 34 for the purpose of adjusting dielectric properties or mechanical properties, in addition to the viscoelastic material such as cyanoethylated PVA as necessary.

Examples of the dielectric polymer material that can be added thereto include a fluorine-based polymer such as polyvinylidene fluoride, a vinylidene fluoride-tetrafluoroethylene copolymer, a vinylidene fluoride-trifluoroethylene copolymer, a polyvinylidene fluoride-trifluoroethylene copolymer, or a polyvinylidene fluoride-tetrafluoroethylene copolymer, a polymer containing a cyano group or a cyanoethyl group such as a vinylidene cyanide-vinyl acetate copolymer, cyanoethyl cellulose, cyanoethyl hydroxysaccharose, cyanoethyl hydroxycellulose, cyanoethyl hydroxypullulan, cyanoethyl methacrylate, cyanoethyl acrylate, cyanoethyl hydroxyethyl cellulose, cyanoethyl amylose, cyanoethyl hydroxypropyl cellulose, cyanoethyl dihydroxypropyl cellulose, cyanoethyl hydroxypropyl amylose, cyanoethyl polyacrylamide, cyanoethyl polyacrylate, cyanoethyl pullulan, cyanoethyl polyhydroxymethylene, cyanoethyl glycidol pullulan, cyanoethyl saccharose, or cyanoethyl sorbitol, and synthetic rubber such as nitrile rubber or chloroprene rubber. Among these, a polymer material containing a cyanoethyl group is suitably used.

Further, the number of kinds of the dielectric polymers to be added to the matrix 34 of the piezoelectric layer 20 in addition to the material having a viscoelasticity at room temperature, such as cyanoethylated PVA, is not limited to one, and a plurality of kinds of the materials may be added.

In addition, for the purpose of adjusting the glass transition point Tg, a thermoplastic resin such as a vinyl chloride resin, polyethylene, polystyrene, a methacrylic resin, polybutene, or isobutylene, and a thermosetting resin such as a phenol resin, a urea resin, a melamine resin, an alkyd resin, or mica may be added to the matrix 34 in addition to the dielectric polymers. Further, for the purpose of improving the pressure sensitive adhesiveness, a viscosity imparting agent such as rosin ester, rosin, terpene, terpene phenol, or a petroleum resin may be added.

In the matrix 34 of the piezoelectric layer 20, the addition amount in a case of adding materials other than the polymer material having viscoelasticity such as cyanoethylated PVA is not particularly limited, but is preferably set to 30% by mass or less in terms of the proportion of the materials in the matrix 34. In this manner, the characteristics of the polymer material to be added can be exhibited without impairing the viscoelasticity relaxing mechanism in the matrix 34, and thus preferable results, for example, an increase in the dielectric constant, improvement of the heat resistance, and improvement of the adhesiveness between the piezoelectric particles 36 and the electrode layer can be obtained.

The piezoelectric layer 20 is a polymer-based piezoelectric composite material containing the piezoelectric particles 36 in such a matrix 34.

The piezoelectric particles 36 consist of ceramics particles having a perovskite type or wurtzite type crystal structure. As the ceramics particles forming the piezoelectric particles 36, for example, lead zirconate titanate (PZT), lead lanthanum zirconate titanate (PLZT), barium titanate ($BaTiO_3$), zinc oxide (ZnO), and a solid solution (BFBT) of barium titanate and bismuth ferrite are exemplified. Only one of these piezoelectric particles 36 may be used, or a plurality of types thereof may be used in combination (mixture).

The particle diameter of the piezoelectric particles 36 is as described above.

In Fig. 1, the piezoelectric particles 36 in the piezoelectric layer 20 are uniformly dispersed in the matrix 34 with regularity, but the present invention is not limited thereto. That is, the piezoelectric particles 36 in the piezoelectric layer 20 may be irregularly dispersed in the matrix 34 as long as the piezoelectric particles 36 are preferably uniformly dispersed therein.

In the piezoelectric film 10, the ratio between the amount of the matrix 34 and the amount of the piezoelectric particles 36 in the piezoelectric layer 20 is not limited and may be appropriately set according to the size and the thickness of the piezoelectric film 10 in the plane direction, the applications of the piezoelectric film 10, the characteristics required for the piezoelectric film 10, and the like. The volume fraction of the piezoelectric particles 36 in the piezoelectric layer 20 is preferably in a range of 30% to 80%, more preferably 50% or greater, and still more preferably in a range of 50% to 80%. By setting the ratio between the amount of the matrix 34 and the amount of the piezoelectric particles 36 to be in the above-described ranges, preferable results in terms of achieving both of excellent piezoelectric characteristics and flexibility can be obtained.

In the piezoelectric film 10 described above, as a preferred embodiment, the piezoelectric layer 20 is a polymer-based piezoelectric composite material layer in which piezoelectric particles are dispersed in the viscoelastic matrix containing a polymer material having viscoelasticity at room temperature. However, the present invention is not limited thereto, and a polymer-based piezoelectric composite material in which piezoelectric particles are dispersed in a matrix containing a polymer material, which is used in a known piezoelectric element, can be used as a piezoelectric layer.

Further, the thickness of the piezoelectric layer 20 is not particularly limited and may be appropriately set according to the applications of the piezoelectric film 10, the characteristics required for the piezoelectric film 10, and the like. The thicker the piezoelectric layer 20, the more advantageous it is in terms of rigidity such as the intensity of stiffness of a so-called sheet-like material, but the voltage (potential difference) required to stretch and contract the piezoelectric film 10 by the same amount increases. The thickness of the piezoelectric layer 20 is preferably in a range of 10 to 300 $\mu$m, more preferably in a range of 20 to 200 $\mu$m, and still more preferably in a range of 30 to 150 $\mu$m. By setting the thickness of the piezoelectric layer 20 to be in the above-described range, preferable results in terms of achieving both ensuring of the rigidity and moderate elasticity can be obtained.

<Protective layer>

The first protective layer 28 and the second protective layer 30 in the piezoelectric film 10 have a function of coating the second electrode layer 26 and the first electrode layer 24 and imparting moderate rigidity and mechanical strength to the piezoelectric layer 20. That is, the piezoelectric layer 20 consisting of the matrix 34 and the piezoelectric particles 36 in the piezoelectric film 10 exhibits extremely excellent flexibility under bending deformation at a slow vibration, but may have insufficient rigidity or mechanical strength depending on the applications. As a compensation for this, the piezoelectric film 10 is provided with the first protective layer 28 and the second protective layer 30.

The first protective layer 28 and the second protective layer 30 are not limited, and various sheet-like materials can be used, and suitable examples thereof include various resin films. Among these, from the viewpoints of excellent mechanical characteristics and heat resistance, a resin film consisting of polyethylene terephthalate (PET), polypropylene (PP), polystyrene (PS), polycarbonate (PC), polyphenylene sulfite (PPS), polymethylmethacrylate (PMMA), polyetherimide (PEI), polyimide (PI), polyethylene naphthalate (PEN), triacetyl cellulose (TAC), and a cyclic olefin-based resin is suitably used.

The thickness of the first protective layer 28 and the second protective layer 30 is not limited. In addition, the thicknesses of the first protective layer 28 and the second protective layer 30 are basically the same as each other, but may be different from each other. Here, in a case where the rigidity of the first protective layer 28 and the second protective layer 30 is extremely high, not only is the stretch and contraction of the piezoelectric layer 20 constrained, but also the flexibility is impaired. Therefore, it is advantageous that the thickness of the first protective layer 28 and the thickness of the second protective layer 30 decrease except for the case where the mechanical strength or satisfactory handleability as a sheet-like material is required.

In a case where the thickness of the first protective layer 28 and the second protective layer 30 in the piezoelectric film 10 is two times or less the thickness of the piezoelectric layer 20, preferable results in terms of achieving both ensuring of the rigidity and moderate elasticity can be obtained.

For example, in a case where the thickness of the piezoelectric layer 20 is 50 $\mu$m and the first protective layer 28 and the second protective layer 30 consist of PET, the thickness of the first protective layer 28 and the second protective layer 30 is preferably 100 $\mu$m or less, more preferably 50 $\mu$m or less, and still more preferably 25 $\mu$m or less.

<Electrode layer>

In the piezoelectric film 10, the first electrode layer 24 is formed between the piezoelectric layer 20 and the first protective layer 28, and the second electrode layer 26 is formed between the piezoelectric layer 20 and the second protective layer 30. The first electrode layer 24 and the second electrode layer 26 are provided to apply a voltage to the piezoelectric layer 20 (piezoelectric film 10).

In the present invention, the material for forming the first electrode layer 24 and the second electrode layer 26 is not limited, and various conductors can be used as the material. Specific examples thereof include metals such as carbon, palladium, iron, tin, aluminum, nickel, platinum, gold, silver, copper, titanium, chromium, and molybdenum, alloys thereof, laminates and composites of these metals and alloys, and indium tin oxide. Among these, copper, aluminum, gold, silver, platinum, and indium tin oxide are suitable as the material of the first electrode layer 24 and the second electrode layer 26.

In addition, a method of forming the first electrode layer 24 and the second electrode layer 26 is not limited, and various known methods, for example, a vapor-phase deposition method (a vacuum film forming method) such as vacuum vapor deposition, ion-assisted vapor deposition, or sputtering, a film forming method of using plating, and a method of bonding a foil formed of the materials described above can be used.

Among these, particularly from the viewpoint of ensuring the flexibility of the piezoelectric film 10, a thin film made of copper, aluminum, or the like formed by vacuum vapor deposition is suitably used as the first electrode layer 24 and the second electrode layer 26. Among these, particularly a thin film made of copper formed by vacuum vapor deposition is suitably used.

The thicknesses of the first electrode layer 24 and the second electrode layer 26 are not limited. In addition, the thicknesses of the first electrode layer 24 and the second electrode layer 26 are basically the same as each other, but may be different from each other.

Here, similarly to the first protective layer 28 and the second protective layer 30 described above, in a case where the rigidity of the first electrode layer 24 and the second electrode layer 26 is extremely high, not only is the stretch and contraction of the piezoelectric layer 20 constrained, but also the flexibility is impaired. Therefore, from the viewpoints of the flexibility and the piezoelectric characteristics, the first electrode layer 24 and the second electrode layer 26 are more advantageous as the thicknesses thereof decrease. That is, it is preferable that the first electrode layer 24 and the second electrode layer 26 are thin film electrodes.

The thickness of each of the first electrode layer 24 and the second electrode layer 26 is less than the thickness of the protective layer, and is preferably in a range of 0.05 $\mu$m to 10 $\mu$m, more preferably in a range of 0.05 $\mu$m to 5 $\mu$m, still more preferably in a range of 0.08 $\mu$m to 3 $\mu$m, and particularly preferably in a range of 0.1 $\mu$m to 2 $\mu$m.

It is suitable that the product of the thickness and the Young's modulus of the first electrode layer 24 and the second electrode layer 26 of the piezoelectric film 10 is less than the product of the thickness and the Young's modulus of the first protective layer 28 and the second protective layer 30 from the viewpoint that the flexibility is not considerably impaired.

For example, in a combination in which the first protective layer 28 and the second protective layer 30 are made of PET (Young's modulus: approximately 6.2 GPa) and the first electrode layer 24 and the second electrode layer 26 consist of copper (Young's modulus: approximately 130 GPa), in a case where the thickness of the first protective layer 28 and the second protective layer 30 is assumed to be 25 $\mu$m, the thickness of the first electrode layer 24 and the second electrode layer 26 is preferably 1.2 $\mu$m or less, more preferably 0.3 $\mu$m or less, and still more preferably 0.1 $\mu$m or less.

As described above, it is preferable that the piezoelectric film 10 has a configuration in which the piezoelectric layer 20 obtained by dispersing the piezoelectric particles 36 in the matrix 34 containing the polymer material that has a viscoelasticity at room temperature is sandwiched between the first electrode layer 24 and the second electrode layer 26 and this laminate is sandwiched between the first protective layer 28 and the second protective layer 30.

It is preferable that, in such a piezoelectric film 10, the maximal value of the loss tangent (tan$\delta$) at a frequency of 1 Hz according to dynamic viscoelasticity measurement is present at room temperature and more preferable that the maximal value at which the loss tangent is 0.1 or greater is present at room temperature. In this manner, even in a case where the piezoelectric film 10 is subjected to large bending deformation at a relatively slow vibration of less than or equal to a few Hz from the outside, since the strain energy can be effectively diffused to the outside as heat, occurrence of cracks at the interface between the polymer matrix and the piezoelectric particles can be prevented.

In the piezoelectric film 10, it is preferable that the storage elastic modulus (E') at a frequency of 1 Hz according to the dynamic viscoelasticity measurement is in a range of 10 to 30 GPa at 0°C and in a range of 1 to 10 GPa at 50°C. The same applies to the conditions for the piezoelectric layer 20. In this manner, the piezoelectric film 10 may have large frequency dispersion in the storage elastic modulus (E'). That is, the piezoelectric film 10 can exhibit a behavior of being rigid with respect to a vibration of 20 Hz to 20 kHz and being flexible with respect to a vibration of less than or equal to a few Hz.

In the piezoelectric film 10, it is preferable that the product of the thickness and the storage elastic modulus (E') at a frequency of 1 Hz according to the dynamic viscoelasticity measurement is in a range of $1.0\times10^6$ to $2.0\times10^6$ N/m at 0°C and in a range of $1.0\times10^5$ to $1.0\times10^6$ N/m at 50°C. The same applies to the conditions for the piezoelectric layer 20. In this manner, the piezoelectric film 10 may have moderate rigidity and mechanical strength within a range not impairing the flexibility and the acoustic characteristics.

Further, in the piezoelectric film 10, it is preferable that the loss tangent (Tan$\delta$) at a frequency of 1 kHz at 25°C is 0.05 or greater in a master curve obtained from the dynamic viscoelasticity measurement. The same applies to the conditions for the piezoelectric layer 20. In this manner, the frequency of a speaker formed of the piezoelectric film 10 is smooth as the frequency characteristic thereof, and thus an amount of a change in acoustic quality in a case where the lowest resonance frequency $f_0$ is changed according to a change in the curvature of the speaker can be decreased.

In the present invention, the storage elastic modulus (Young's modulus) and the loss tangent of the piezoelectric film 10, the piezoelectric layer 20, and the like may be measured by a known method. As an example, the measurement may be performed using a dynamic viscoelasticity measuring device DMS6100 (manufactured by SII Nanotechnology Inc.).

Examples of the measurement conditions include a measurement frequency of 0.1 Hz to 20 Hz (0.1 Hz, 0.2 Hz, 0.5 Hz, 1 Hz, 2 Hz, 5 Hz, 10 Hz, and 20 Hz), a measurement temperature of -50°C to 150°C, a temperature rising rate of 2°C/min (in a nitrogen atmosphere), a sample size of 40 mm $\times$ 10 mm (including the clamped region), and a chuck-to-chuck distance of 20 mm.

Next, an example of the method of producing the piezoelectric film 10 will be described with reference to Figs. 2 to 5.

First, as illustrated in Fig. 2, a sheet-like material 10a in which the first electrode layer 24 is formed on the first protective layer 28 is prepared. The sheet-like material 10a may be prepared by forming a copper thin film or the like as the first electrode layer 24 on the surface of the first protective layer 28 by carrying out vacuum vapor deposition, sputtering, plating, or the like.

In a case where the first protective layer 28 is extremely thin and thus the handleability is degraded, the first protective layer 28 with a separator (temporary support) may be used as necessary. Further, a PET having a thickness of 25 $\mu$m to 100 $\mu$m or the like can be used as the separator. The separator may be removed after thermal compression bonding of the second electrode layer 26 and the second protective layer 30 and before lamination of any member on the first protective layer 28.

On the other hand, the piezoelectric particles 36 are prepared.

First, powder of an oxide of Pb, an oxide of Zr, and an oxide of Ti, which are main components, is mixed as starting materials in an amount ratio according to the composition of the entirety of the piezoelectric particles to prepare raw material powder. The raw material powder is prepared by using a ball mill or the like.

This raw material mixed powder is placed in a crucible or the like and calcined. From the viewpoint of adjusting the circularity to be in a suitable range, the calcining temperature is preferably approximately 700°C to 900°C, and the calcination time is preferably approximately 3 hours to 6 hours.

After completion of the calcination, the prepared piezoelectric particles are crushed as necessary. The crushing may be carried out by a known method such as a method using a ball mill or a method of placing particles on a mesh, applying a pressure thereto from above, and allowing the particles to pass through the mesh. In a case where the piezoelectric particles are crushed by the method of using a ball mill, the crushing time is preferably 3 hours to 40 hours.

Next, a coating material that is formed into the piezoelectric layer is prepared. The coating material is prepared by dissolving a polymer material serving as a material of the matrix in an organic solvent, adding the piezoelectric particles 36 thereto, and stirring the solution for dispersion.

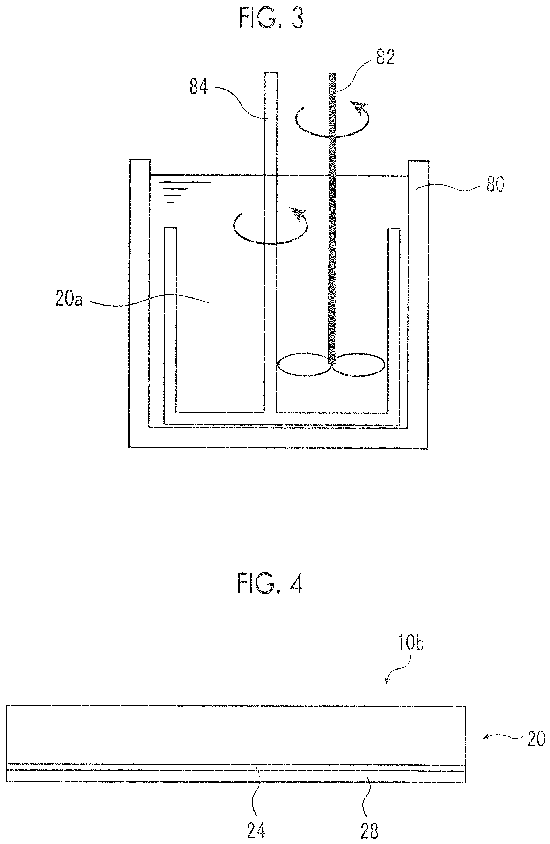

Here, in the present invention, it is preferable that a coating material 20a stored in a stirring tank 80 is stirred by two kinds of stirring blades, which are a propeller type stirring blade 82 and an anchor type stirring blade 84 as illustrated in Fig. 3, in order to set the circularity of the piezoelectric particles to be in a range of 0.80 to 0.88.

The propeller type stirring blade 82 is a typical propeller type stirring blade. Further, the anchor type stirring blade 84 is a typical anchor type stirring blade.

In the related art, stirring has been performed using a propeller type stirring blade (propeller mixer), but in a case where stirring is performed using a propeller mixer, since one propeller mixer performs two functions of preventing sedimentation of piezoelectric particles and dispersing piezoelectric particles, the rotation speed of the propeller mixer is required to be increased. Accordingly, a high shearing force is applied, the piezoelectric particles are excessively crushed so that the piezoelectric particles are chipped and the corners are removed, and thus the piezoelectric particles are rounded. Therefore, the piezoelectric particles have a shape close to a perfect circle. That is, the circularity thereof is increased. On the other hand, in a case where the rotation speed of the propeller mixer is decreased, sedimentation of the piezoelectric particles occurs so that the piezoelectric particles are not sufficiently dispersed and unlikely to be crushed, and thus the circularity of the piezoelectric particles may be decreased.

On the contrary, in the stirring carried out using the propeller type stirring blade 82 and the anchor type stirring blade 84 at the same time, the sedimentation of the piezoelectric particles is mainly prevented by the stirring carried out using the anchor type stirring blade 84 having a shape along the bottom surface and the side surface of the stirring tank 80. In addition, the diffusion of the piezoelectric particles is mainly promoted by the stirring carried out using the propeller type stirring blade 82.

That is, in a case where the sedimentation is prevented by stirring the piezoelectric particles using the anchor type stirring blade 84, the piezoelectric particles can be sufficiently dispersed even in a case where the rotation speed of the propeller type stirring blade 82 is decreased. Therefore, in a case where the rotation speeds of each of the anchor type stirring blade 84 and the propeller type stirring blade 82 are adjusted, an appropriate shearing force is applied to appropriately crush the piezoelectric particles, and thus the circularity of the piezoelectric particles can be adjusted.

The rotation speeds of the anchor type stirring blade 84 and the propeller type stirring blade 82 may be appropriately set according to the viscosity of the coating material, the volume fraction of the piezoelectric particles, the size and the shape of each stirring blade, the size of the stirring tank, and the like.

The rotation speed of the anchor type stirring blade 84 may be set to a rotation speed at which the function of preventing the sedimentation of the piezoelectric particles can be obtained, and is preferably in a range of 10 rpm to 100 rpm, more preferably in a range of 20 rpm to 90 rpm, and still more preferably in a range of 30 rpm to 80 rpm.

The rotation speed of the propeller type stirring blade 82 may be set to a rotation speed at which the function of diffusing the piezoelectric particles is obtained and the piezoelectric particles are appropriately crushed, and is preferably in a range of 200 rpm to 1000 rpm, more preferably in a range of 300 rpm to 900 rpm, and still more preferably in a range of 400 rpm to 800 rpm.

In a case where the sheet-like material 10a is prepared and the coating material is prepared, the coating material is cast (applied) onto the sheet-like material 10a, and the organic solvent is evaporated and dried. In this manner, as illustrated in Fig. 4, a laminate 10b in which the first electrode layer 24 is provided on the first protective layer 28 and the piezoelectric layer 20 is formed on the first electrode layer 24 is prepared.

A casting method of the coating material is not limited, and all known methods (coating devices) such as a slide coater or a doctor knife can be used.

As described above, in the piezoelectric film 10, in addition to the viscoelastic material such as cyanoethylated PVA, a dielectric polymer material may be added to the matrix 34.

In a case where the polymer material is added to the matrix 34, the polymer material added to the coating material may be dissolved.

In a case where the laminate 10b in which the first electrode layer 24 is provided on the first protective layer 28 and the piezoelectric layer 20 is formed on the first electrode layer 24 is prepared, it is preferable that the piezoelectric layer 20 is subjected to a polarization treatment (poling). A method of performing the polarization treatment on the piezoelectric layer 20 is not limited, and a known method can be used.

Before the polarization treatment, a calender treatment may be performed to smoothen the surface of the piezoelectric layer 20 using a heating roller or the like. By performing the calender treatment, a thermal compression bonding step described below can be smoothly performed.

In this manner, while the piezoelectric layer 20 of the laminate 10b is subjected to the polarization treatment, a sheet-like material 10c in which the second electrode layer 26 is formed on the second protective layer 30 is prepared. The sheet-like material 10c may be prepared by forming a copper thin film or the like as the second electrode layer 26 on the surface of the second protective layer 30 using vacuum vapor deposition, sputtering, plating, or the like.

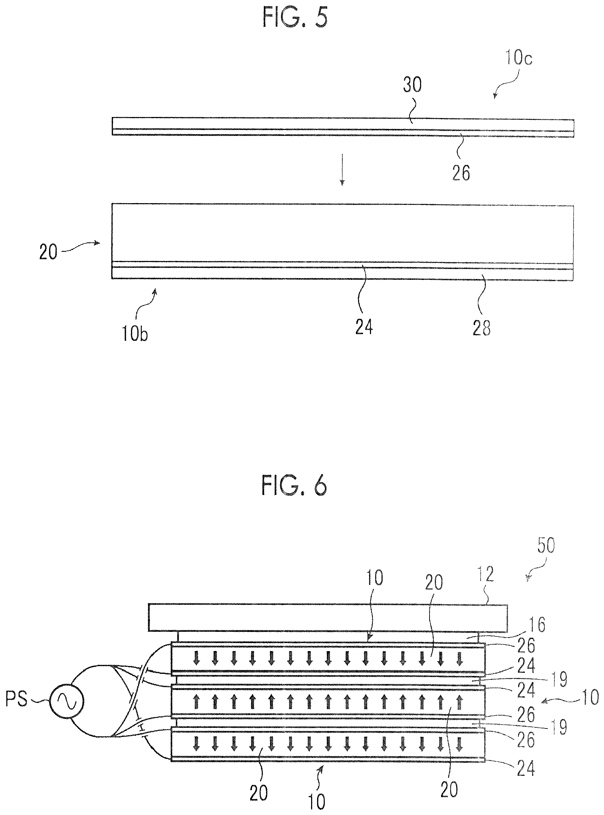

Next, as illustrated in Fig. 5, the sheet-like material 10c is laminated on the laminate 10b in which the polarization treatment performed on the piezoelectric layer 20 is completed in a state where the second electrode layer 26 is directed toward the piezoelectric layer 20.

Further, a laminate of the laminate 10b and the sheet-like material 10c is subjected to the thermal compression bonding using a heating press device, a pair of heating rollers, or the like such that the second protective layer 30 and the first protective layer 28 are sandwiched, thereby preparing the piezoelectric film 10. In addition, the laminate may be cut into a desired shape after the thermal compression bonding.

Further, the steps described so far can also be performed by using a web-like material, that is, a material wound up in a state where long sheets are connected without using a sheet-like material, during transport. Both the laminate 10b and the sheet-like material 10c have a web shape and can be subjected to thermal compression bonding as described above. In that case, the piezoelectric film 10 is prepared in a web shape at this time point.

Further, an adhesive layer may be provided in a case where the laminate 10b and the sheet-like material 10c are bonded to each other. For example, an adhesive layer may be provided on the surface of the second electrode layer 26 of the sheet-like material 10c. The most suitable adhesive layer is formed of the same material as the material of the matrix 34. The piezoelectric layer 20 may be coated with the same material or the surface of the second electrode layer 26 can be coated with the same material and bonded.

Here, a typical piezoelectric film consisting of a polymer material such as polyvinylidene difluoride (PVDF) has in-plane anisotropy as a piezoelectric characteristic and is anisotropic in the amount of expansion and contraction in the plane direction in a case where a voltage is applied.

On the contrary, the piezoelectric layer which is included in the piezoelectric film according to the embodiment of the present invention and consists of a polymer-based piezoelectric composite material that contains piezoelectric particles in a matrix containing a polymer material has no in-plane anisotropy as a piezoelectric characteristic and stretches and contracts isotropically in all directions in the in-plane direction. According to the piezoelectric film 10 that stretches and contracts isotropically and two-dimensionally as described above, the piezoelectric film can be vibrated with a larger force and a louder and more beautiful sound can be generated as compared with a case of a typical piezoelectric film formed of PVDF or the like that stretches and contracts greatly in only one direction.

Further, the piezoelectric film according to the embodiment of the present invention can also be used as a speaker of a display device, for example, by being bonded to a display device having flexibility such as an organic electroluminescence display having flexibility or a liquid crystal display having flexibility.

Further, for example, in a case where the piezoelectric film 10 is used as a speaker, the piezoelectric film 10 may be used as a speaker that generates a sound from the vibration of the film-like piezoelectric film. Alternatively, the piezoelectric film 10 may be used as an exciter that generates a sound by being attached to a vibration plate to vibrate the vibration plate, from the vibration of the piezoelectric film 10.

In addition, the piezoelectric film 10 according to the embodiment of the present invention satisfactorily functions as a piezoelectric vibrating element that vibrates a vibrating body such as a vibration plate by laminating a plurality of the piezoelectric films to obtain a laminated piezoelectric element.

As an example, as illustrated in Fig. 6, the laminated piezoelectric element 50 obtained by laminating the piezoelectric films 10 is bonded to the vibration plate 12 and may be used as a speaker that allows the laminate of the piezoelectric films 10 to vibrate the vibration plate 12 and outputs a sound. That is, in this case, the laminate of the piezoelectric film 10 acts as a so-called exciter that outputs a sound by vibrating the vibration plate 12.

By applying a driving voltage to the laminated piezoelectric element 50 obtained by laminating the piezoelectric films 10, each of the piezoelectric films 10 stretches and contracts in the plane direction, and the entire laminate of the piezoelectric films 10 stretches and contracts in the plane direction due to the stretch and contraction of each of the piezoelectric films 10. The vibration plate 12 to which the laminate has been bonded is bent due to the stretch and contraction of the laminated piezoelectric element 50 in the plane direction, and as a result, the vibration plate 12 vibrates in the thickness direction. The vibration plate 12 generates a sound due to the vibration in the thickness direction. That is, the vibration plate 12 vibrates according to the magnitude of the driving voltage applied to the piezoelectric film 10, and generates a sound according to the driving voltage applied to the piezoelectric film 10. Therefore, the piezoelectric film 10 itself does not output sound in this case.

Therefore, even in a case where the rigidity of each piezoelectric film 10 is low and the stretching and contracting force thereof is small, the rigidity of the laminated piezoelectric element 50 obtained by laminating the piezoelectric films 10 is increased, and the stretching and contracting force as the entire laminate is increased. As a result, in the laminated piezoelectric element 50 obtained by laminating the piezoelectric films 10, even in a case where the vibration plate has a certain degree of rigidity, the vibration plate 12 is sufficiently bent with a large force and can be sufficiently vibrated in the thickness direction, and thus the vibration plate 12 can generate a sound.

In the laminated piezoelectric element 50 obtained by laminating the piezoelectric films 10, the number of laminated sheets of the piezoelectric films 10 is not limited, and the number of sheets set such that a sufficient amount of vibration is obtained may be appropriately set according to, for example, the rigidity of the vibration plate 12 to be vibrated. Further, one piezoelectric film 10 can also be used as a similar exciter (piezoelectric vibrating element) in a case where the piezoelectric film 10 has a sufficient stretching and contracting force.

The vibration plate 12 that is vibrated by the laminated piezoelectric element 50 obtained by laminating the piezoelectric films 10 is not limited, and various sheet-like materials (platelike materials and films) can be used. Examples thereof include a resin film consisting of polyethylene terephthalate (PET) and the like, foamed plastic consisting of foamed polystyrene and the like, a paper material such as a corrugated cardboard material, a glass plate, and wood. Further, various machines (devices) such as display devices such as an organic electroluminescence display and a liquid crystal display may be used as the vibration plate as long as the devices can be sufficiently bent.

It is preferable that the laminated piezoelectric element 50 obtained by laminating the piezoelectric films 10 is formed by bonding the adjacent piezoelectric films 10 with a bonding layer 19 (bonding agent). Further, it is preferable that the laminated piezoelectric element 50 and the vibration plate 12 are also bonded with a bonding layer 16.

The bonding layer is not limited, and various layers that can bond materials to be bonded can be used. Therefore, the bonding layer may consist of a pressure sensitive adhesive or an adhesive. It is preferable that an adhesive layer consisting of an adhesive is used from the viewpoint that a solid and hard bonding layer is obtained after the bonding. The same applies to the laminate formed by folding back the long piezoelectric film 10 described below.

In the laminated piezoelectric element 50 obtained by laminating the piezoelectric films 10, the polarization direction of each piezoelectric film 10 to be laminated is not limited. It is preferable that the piezoelectric film 10 according to the embodiment of the present invention is polarized in the thickness direction. The polarization direction of the piezoelectric film 10 here is a polarization direction in the thickness direction. Therefore, in the laminated piezoelectric element 50, the polarization directions may be the same for all the piezoelectric films 10, and piezoelectric films having different polarization directions may be present.

In a laminated piezoelectric element 50 obtained by laminating the piezoelectric films 10, it is preferable that the piezoelectric films 10 are laminated such that the adjacent piezoelectric films 10 have polarization directions opposite to each other. In the piezoelectric film 10, the polarity of the voltage to be applied to the piezoelectric layer 20 depends on the polarization direction of the piezoelectric layer 20. Therefore, even in a case where the polarization direction is directed from the second electrode layer 26 toward the first electrode layer 24 or from the first electrode layer 24 toward the second electrode layer 26, the polarity of the second electrode layer 26 and the polarity of the first electrode layer 24 in all the piezoelectric films 10 to be laminated are set to be the same as each other. Therefore, by reversing the polarization directions of the adjacent piezoelectric films 10, even in a case where the electrode layers of the adjacent piezoelectric films 10 come into contact with each other, the electrode layers in contact with each other have the same polarity, and thus there is no risk of a short circuit.

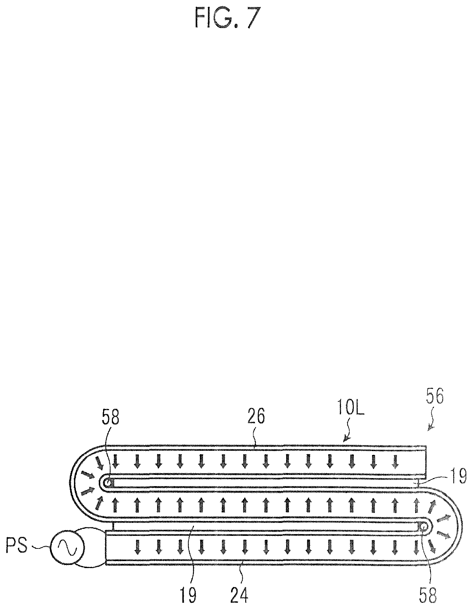

The laminated piezoelectric element obtained by laminating the piezoelectric films 10 may have a configuration in which a plurality of piezoelectric films 10 are laminated by folding a piezoelectric film 10L once or more times, preferably a plurality of times, as illustrated in Fig. 7. The laminated piezoelectric element 56 obtained by folding back and laminating the piezoelectric film 10 has the following advantages.

In the laminate in which a plurality of cut sheet-like piezoelectric films 10 are laminated, the second electrode layer 26 and the first electrode layer 24 need to be connected to a driving power supply for each piezoelectric film. On the contrary, in the configuration in which the long piezoelectric film 10L is folded back and laminated, only one sheet of the long piezoelectric film 10L can form the laminated piezoelectric element 56. Therefore, in the configuration in which the long piezoelectric film 10L is folded back and laminated, only one power source is required for applying the driving voltage, and the electrode may be led out from the piezoelectric film 10L at one site. Further, in the configuration in which the long piezoelectric film 10L is folded back and laminated, the polarization directions of the adjacent piezoelectric films are inevitably opposite to each other.

Further, such a laminated piezoelectric element obtained by laminating the piezoelectric film including electrode layers and protective layers provided on both surfaces of a piezoelectric layer consisting of a polymer-based piezoelectric composite material is described in WO2020/095812A and WO2020/179353A.

Hereinbefore, the piezoelectric film according to the embodiment of the present invention has been described in detail, but the present invention is not limited to the above-described examples, and various improvements or modifications may be made within a range not departing from the scope of the present invention.

Examples

Hereinafter, the present invention will be described in more detail with reference to specific examples of the present invention. Further, the present invention is not limited to the examples, and the materials, the used amounts, the proportions, the treatment contents, the treatment procedures, and the like shown in the following examples can be appropriately changed within a range not departing from the scope of the present invention.

[Example 1]

Sheet-like materials 10a and 10c formed by sputtering a copper thin film having a thickness of 100 nm on a PET film having a thickness of 4 μm were prepared. That is, in the present example, the first electrode layer 24 and the second electrode layer 26 were copper thin films having a thickness of 100 nm, and the first protective layer 28 and the second protective layer 30 were PET films having a thickness of 4 μm.

Further, in order to obtain satisfactory handleability during the process, a film with a separator (temporary support PET) having a thickness of 50 μm was used as the PET film, and the separator of each protective layer was removed after the thermal compression bonding of the sheet-like material 10c.

Meanwhile, powders of an oxide of Pb, an oxide of Zr, and an oxide of Ti serving as main components was mixed as starting materials.

Next, the obtained raw material mixed powder was calcined at 700°C to 800°C. After the calcination, the powder was dry-pulverized using a ball mill with a ball diameter of 1 mm, a ball filling ratio of 30%, and a rotation speed of 60 rpm for 10 hours, thereby obtaining piezoelectric particles 36.

First, cyanoethylated PVA (CR-V, manufactured by Shin-Etsu Chemical Co., Ltd.) was dissolved in methyl ethyl ketone (MEK). Thereafter, the piezoelectric particles 36 obtained above were added to this solution at the following compositional ratio, and the solution was stirred using the propeller type stirring blades 82 and the anchor type stirring blades 84, thereby preparing a coating material 20a for forming the piezoelectric layer 20.

· PZT Particles: 300 parts by mass
· Cyanoethylated PVA: 15 parts by mass
· MEK: 85 parts by mass

The size of the stirring tank 80 was set such that the stirring tank had a diameter of Φ400 mm and a height of 600 mm. As the propeller type stirring blade 82, a propeller blade (6-blade pitched disk turbine, manufactured by Satake Multimix Corporation) having a blade diameter of 100 mm was used. As the anchor type stirring blade 84, an anchor paddle (manufactured by Satake Multimix Corporation) having a blade diameter of 350 mm was used. The rotation speed of the propeller type stirring blade 82 was set to 200 rpm. The rotation speed of the anchor type stirring blade 84 was set to 60 rpm.

The first electrode layer 24 (copper thin film) of the sheet-like material 10a prepared in advance was coated with the coating material 20a for forming the piezoelectric layer 20 prepared in advance using a slide coater. Further, the coating material was applied such that the film thickness of the coating film after being dried reached 25 μm.

Next, the material obtained by coating the sheet-like material 10a with the coating material was placed on a hot plate at 120°C, and the coating film was heated and dried. In this manner, MEK was evaporated to form a laminate 10b.

Next, the sheet-like material 10c was laminated on the laminate 10b in a state where the second electrode layer 26 (copper thin film side) side faced the piezoelectric layer 20, and subjected to thermal compression bonding at 120°C.

In this manner, a piezoelectric film 10 including the first protective layer 28, the first electrode layer 24, the piezoelectric layer 20, the second electrode layer 26, and the second protective layer 30 in this order was prepared.

The prepared piezoelectric film 10 was machined in the thickness direction by the method described above, an image of a cross section was acquired by an SEM, this image was binarized, and the circularity and the average particle diameter of the piezoelectric particles were acquired as the average value of the N5 visual field. The measurement results are listed in Table 1.

[Examples 2 to 5]

Each piezoelectric film was prepared in the same manner as in Example 1 except that the rotation speeds of the propeller type stirring blades 82 were respectively set to 300 rpm, 500 rpm, 700 rpm, and 1000 rpm. The circularity and the average particle diameter of the piezoelectric particles of the prepared piezoelectric film were measured by the same method as described above.

[Examples 6 to 12]

Each piezoelectric film was prepared in the same manner as in Example 3 except that the times for dry pulverization using the ball mill were respectively set to 0.5 hour, 1 hour, 3 hours, 5 hours, 20 hours, 40 hours, and 100 hours. The circularity and the average particle diameter of the piezoelectric particles of the prepared piezoelectric film were measured by the same method as described above.

[Comparative Example 1]

A piezoelectric film was prepared in the same manner as in Example 1 except that the rotation speed of the propeller type stirring blades 82 was set to 2000 rpm. The circularity and the average particle diameter of the piezoelectric particles of the prepared piezoelectric film were measured by the same method as described above.

[Comparative Examples 2 and 3]

Each piezoelectric film was prepared in the same manner as in Example 1 except that the anchor type stirring blade 84 was not used and the rotation speeds of the propeller type stirring blade 82 were respectively set to 2000 rpm and 1000 rpm. The circularity and the average particle diameter of the piezoelectric particles of the prepared piezoelectric film were measured by the same method as described above.

[Comparative Examples 4 and 5]

Each piezoelectric film was prepared in the same manner as in Example 1 except that the propeller type stirring blade 82 was not used and the rotation speeds of the anchor type stirring blade 84 were respectively set to 60 rpm and 20 rpm. The circularity and the average particle diameter of the piezoelectric particles of the prepared piezoelectric film were measured by the same method as described above.

[Evaluation]

First, a rectangular test piece having a size of $210 \times 300$ mm (A4 size) was cut out from the prepared piezoelectric film. The cut-out piezoelectric film was placed on a case having an opening portion with a size of $210 \times 300$ mm in which glass wool was stored, the peripheral portion was pressed by a frame to impart an appropriate tension and a curvature to the piezoelectric film, thereby preparing a piezoelectric speaker. The depth of the case was set to 9 mm, the density of glass wool was set to 32 kg/m$^3$, and the thickness before assembly was set to 25 mm.

A 1 kHz sine wave was input to the prepared piezoelectric speaker as an input signal through a power amplifier, and the sound pressure was measured with a microphone placed at a distance of 60 cm from the center of the speaker.

The results are listed in Table 1.

[Table 1]

| | Ball mill | Coating material dispersion method | | Piezoelectric particles | | Evaluation |
|---|---|---|---|---|---|---|
| | Time for dry pulverization hr | Propeller rotation speed rpm | Anchor rotation speed rpm | Circularity | Average particle diameter μm | Sound pressure dB |
| Example 1 | 10 | 200 | 60 | 0.65 | 1.5 | 75.2 |
| Example 2 | 10 | 300 | 60 | 0.73 | 1.44 | 76.8 |
| Example 3 | 10 | 500 | 60 | 0.8 | 1.42 | 81.2 |
| Example 4 | 10 | 700 | 60 | 0.88 | 1.42 | 78.5 |
| Example 5 | 10 | 1000 | 60 | 0.92 | 1.27 | 76.1 |
| Example 6 | 0.5 | 500 | 60 | 0.76 | 7.3 | 73.9 |
| Example 7 | 1 | 500 | 60 | 0.78 | 5.04 | 76.1 |
| Example 8 | 3 | 500 | 60 | 0.79 | 3.22 | 78.3 |
| Example 9 | 5 | 500 | 60 | 0.85 | 2.17 | 80.6 |
| Example 10 | 20 | 500 | 60 | 0.88 | 0.73 | 78.4 |
| Example 11 | 40 | 500 | 60 | 0.89 | 0.51 | 77.7 |
| Example 12 | 100 | 500 | 60 | 0.9 | 0.38 | 76.2 |
| Comparative Example 1 | 10 | 2000 | 60 | 0.95 | 1.38 | 69.6 |
| Comparative Example 2 | 10 | 2000 | None | 0.94 | 1.39 | 68.7 |
| Comparative Example 3 | 10 | 1000 | None | 0.63 | 2.21 | 68.9 |
| Comparative Example 4 | 10 | None | 60 | 0.59 | 2.12 | 67.3 |
| Comparative Example 5 | 10 | None | 30 | 0.57 | 2.43 | 65.8 |

As listed in Table 1, it was found that the piezoelectric film of the present invention had a higher sound pressure and higher piezoelectric performance as compared with the comparative examples.

In Comparative Examples 1 and 2, it was considered that since the rotation speed of the propeller type stirring blade during the dispersion of the coating material was extremely high, the piezoelectric particles were excessively crushed, and thus the circularity of the piezoelectric particles was increased. It was considered that in a case where the circularity was extremely high as described above, the interaction between the adjacent piezoelectric particles was unlikely to be transmitted, and thus the sound pressure was decreased.

In Comparative Example 3, it was considered that since the rotation speed of the propeller type stirring blade was low and the stirring was not carried out by the anchor type stirring blade, sedimentation of the piezoelectric particles occurred, the piezoelectric particles were not sufficiently crushed, and thus the circularity of the piezoelectric particles was decreased. It was considered that in a case where the circularity was extremely low as described above, voids were generated so that the filling ratio of the piezoelectric layer was decreased, and thus the sound pressure was decreased.

In Comparative Examples 4 and 5, it was considered that since the stirring was not carried out by the propeller type stirring blade, the piezoelectric particles were not sufficiently crushed, and thus the circularity of the piezoelectric particles was decreased. It was considered that in a case where the circularity was extremely low as described above, voids were generated so that the filling ratio of the piezoelectric layer was decreased, and thus the sound pressure was decreased.

Based on the comparison of Examples 1 to 5, it was found that the circularity of the piezoelectric particles is in a range of 0.80 to 0.88 according to the invention.

Further, based on the comparison of Examples 3 and 6 to 12, it was found that the average particle diameter of the piezoelectric particles is preferably in a range of 0.5 $\mu$m to 5 $\mu$m.

As shown in the above-described results, the effects of the present invention are clearly exhibited.

The piezoelectric film according to the embodiment of the present invention can be suitably used for various applications, for example, various sensors (particularly useful for infrastructure inspection such as crack detection and inspection at a manufacturing site such as foreign matter contamination detection) such as sound wave sensors, ultrasound sensors, pressure sensors, tactile sensors, strain sensors, and vibration sensors, acoustic devices (specific applications thereof include noise cancellers (used for cars, trains, airplanes, robots, and the like), artificial voice cords, buzzers for preventing invasion of pests and harmful animals, furniture, wallpaper, photos, helmets, goggles, headrests, signage, and robots) such as microphones, pickups, speakers, and exciters, haptics used by being applied to automobiles, smartphones, smart watches, and game machines, ultrasonic transducers such as ultrasound probes and hydrophones, actuators used for water droplet adhesion prevention, transport, stirring, dispersion, and polishing, damping materials (dampers) used for containers, vehicles, buildings, and sports goods such as skis and rackets, and vibration power generation devices used by being applied to roads, floors, mattresses, chairs, shoes, tires, wheels, personal computer keyboards, and the like.

Explanation of References

    10, 10L: piezoelectric film
    10a, 10c: sheet-like material
    10b: laminate
    12: vibration plate
    16, 19: bonding layer
    20: piezoelectric layer
    24: first electrode layer
    26: second electrode layer
    28: first protective layer
    30: second protective layer
    34: matrix
    36: piezoelectric particle
    50, 56: laminated piezoelectric element
    58: core rod
    80: stirring tank
    82: propeller type stirring blade
    84: anchor type stirring blade

**Claims**

1. A piezoelectric film (10, 10L) comprising:

   a piezoelectric layer (20) consisting of a polymer-based piezoelectric composite material that contains piezoelectric particles (36) in a matrix (34) containing a polymer material; and
   electrode layers (24, 26) formed on both surfaces of the piezoelectric layer (20),
   **characterized in that** the piezoelectric particles (36) observed in a cross section of the piezoelectric layer (20) in a thickness direction have a circularity of 0.80 to 0.88, wherein the circularity is calculated according to the expression:

   $$4\pi \times (\text{area}/(\text{circumference length})^2).$$

2. The piezoelectric film according to claim 1,
   wherein the piezoelectric particles have an average particle diameter of 0.5 $\mu$m to 5 $\mu$m.

3. The piezoelectric film according to claim 1 or 2,
   wherein a first protective layer (28) is laminated on the first electrode layer (24) and a second protective layer (30) laminated on the second electrode layer (26).

4. A laminated piezoelectric element (50, 56) formed by laminating a plurality of layers of the piezoelectric film (10, 10L) according to any one of claims 1 to 3.

5. The laminated piezoelectric element (50, 56) according to claim 4, wherein the piezoelectric films (10, 10A) are bonded to a vibration plate (12) by means of a bonding layer (16, 19).


**Patentansprüche**

1. Piezoelektrischer Film (10, 10L), umfassend:

   eine piezoelektrische Schicht (20), die aus einem piezoelektrischen Verbundwerkstoff auf Polymer-Basis besteht, der piezoelektrische Partikel (36) in einer Matrix (34), die ein Polymermaterial enthält, enthält; und
   Elektrodenschichten (24, 26), die auf beiden Oberflächen der piezoelektrischen Schicht (20) gebildet sind,
   **dadurch gekennzeichnet, dass** die piezoelektrischen Partikel (36), die in einem Querschnitt der piezoelektrischen Schicht (20) in einer Dickenrichtung beobachtet werden, eine Rundheit von 0,80 bis 0,88 aufweisen, wobei die Rundheit gemäß dem Ausdruck berechnet wird:

   $$4\pi \times (\text{Fläche}/(\text{Umfangslänge})^2).$$

2. Piezoelektrischer Film nach Anspruch 1,
   wobei die piezoelektrischen Partikel einen durchschnittlichen Partikeldurchmesser von 0,5 $\mu$m bis 5 $\mu$m aufweisen.

3. Piezoelektrischer Film nach Anspruch 1 oder 2,
   wobei eine erste Schutzschicht (28) auf der ersten Elektrodenschicht (24) laminiert ist und eine zweite Schutzschicht (30) auf der zweiten Elektrodenschicht (26) laminiert ist.

4. Laminiertes piezoelektrisches Element (50, 56), das durch Laminieren mehrerer Schichten des piezoelektrischen Films (10, 10L) nach einem der Ansprüche 1 bis 3 gebildet ist.

5. Laminiertes piezoelektrisches Element (50, 56) nach Anspruch 4, wobei die piezoelektrischen Filme (10, 10A) mittels einer Klebeschicht (16, 19) mit einer Schwingungsplatte (12) verbunden sind.

**Revendications**

1. Film piézoélectrique (10, 10L) comprenant :

   une couche piézoélectrique (20) constituée d'un matériau composite piézoélectrique à base de polymère qui contient des particules piézoélectriques (36) dans une matrice (34) contenant un matériau polymère ; et
   des couches d'électrodes (24, 26) formées sur les deux surfaces de la couche piézoélectrique (20),
   **caractérisé en ce que** les particules piézoélectriques (36) observées dans une section transversale de la couche piézoélectrique (20) dans une direction d'épaisseur ont une circularité de 0,80 à 0,88, dans laquelle la circularité est calculée selon l'expression :

   $$4\pi \times (\text{surface}/(\text{longueur de circonférence})^2).$$

2. Film piézoélectrique selon la revendication 1,
   dans lequel les particules piézoélectriques ont un diamètre moyen de particules de 0,5 $\mu$m à 5 $\mu$m.

3. Film piézoélectrique selon la revendication 1 ou la revendication 2,
   dans lequel une première couche protectrice (28) est stratifiée sur la première couche d'électrode (24) et une deuxième couche protectrice (30) est stratifiée sur la deuxième couche d'électrode (26).

4. Élément piézoélectrique stratifié (50, 56) formé en stratifiant une pluralité de couches du film piézoélectrique (10, 10L) selon l'une quelconque des revendications 1 à 3.

5. Élément piézoélectrique stratifié (50, 56) selon la revendication 4, dans lequel les films piézoélectriques (10, 10A) sont liés à une plaque de vibration (12) par l'intermédiaire d'une couche de liaison (16, 19).

FIG. 1

FIG. 2

# FIG. 3

84

82

80

20a

# FIG. 4

10b

20

24    28

FIG. 5

FIG. 6

FIG. 7

**REFERENCES CITED IN THE DESCRIPTION**

**Patent documents cited in the description**

- JP 6043673 B
- US 20150364674 A1
- WO 2020095812 A1
- WO 2020095812 A
- WO 2020179353 A